# EUROPEAN PATENT APPLICATION

(11) **EP 3 407 391 A1**
(43) Date of publication of application: **28.11.2018**
(21) Application number: 18173762.8
(22) Date of filing: 23.05.2018
(51) Int. Cl.: H01L 31/0747, H01L 31/18

(54) **PREPARATION METHOD OF HETEROJUNCTION SOLAR CELL AND HETEROJUNCTION SOLAR CELL**

(30) Priority: 25.05.2017 CN 201710379489
(71) Applicant: Beijing Juntai Innovation Technology Co., Ltd, 100176 Beijing (CN)
(72) Inventor: XU, Xiangang, BEIJING, 100176 (CN); YANG, Miao, BEIJING, 100176 (CN); YU, Cao, BEIJING, 100176 (CN); ZHANG, Jinyan, BEIJING, 100176 (CN); CHEN, Xixiang, BEIJING, 100176 (CN)
(74) Representative: Cabinet Beau de Loménie

(57) **Abstract**

The present invention discloses a preparation method of a heterojunction solar cell and the heterojunction solar cell. The method comprises: providing a substrate; respectively depositing intrinsic layers at two sides of the substrate; respectively depositing n-type doped layers and p-type doped layers on the intrinsic layers at two sides of the substrate, wherein at least two n-type doped layers and/or p-type doped layers are provided, and the doping concentration of each layer of the n-type doped layers and/or the p-type doped layers is gradually increased in a longitudinal direction away from the substrate; and respectively and sequentially forming transparent conductive oxide layers and electrode layers on the n-type doped layers and the p-type doped layers. Therefore, the conversion and production efficiencies of the cell are increased.

## Description

This application is based upon and claims the benefit of priority of Chinese Patent Application No. 201710379489.1 filed on May 25, 2017, the contents of which are incorporated herein by reference in its entirety.

### Technical Field

The present invention relates to the field of new energy and in particular relates to a preparation method of a heterojunction solar cell and the heterojunction solar cell.

### Background Art

With the rapid development of sciences and technologies, the crystalline silicon solar cell has increased conversion efficiency year by year. At present, distributed solar photovoltaic power generation is energetically popularized in China, and a solar cell module with high conversion efficiency is needed due to limited roof resources. Due to various advantages such as high efficiency, low energy consumption, simple process flow and small temperature coefficient, an efficient monocrystalline heterojunction cell will be energetically developed within the next few years, and it is particularly important to increase its efficiency.

A PN structure of a conventional HIT heterojunction cell is a-Si:H(p) (p-type doped layers)/a-Si (intrinsic layer i)/c-Si (monocrystalline silicon)/a-Si (intrinsic layer i) a-Si:H(n) (n-type doped layers), the aim of enhancing a built-in electric field of a PN junction may be achieved by increasing the doping concentrations of the doped layers, however, impurities may be diffused to enter the intrinsic layers while the concentrations of the doped layers are increased, so that the passivation effects of the intrinsic layers are reduced, and furthermore, the conversion efficiency of the cell is also reduced therewith.

How to provide a preparation method of a heterojunction solar cell and the heterojunction solar cell, which not only may guarantee the high doping concentrations, but also may avoid the phenomenon that the impurities are diffused into the intrinsic layers to reduce the conversion efficiency of the cell is a technical problem that needs to be solved by those skilled in the art.

### Summary of the Invention

The present invention provides a preparation method of a heterojunction solar cell in order to solve the problems that the passivation effects of the intrinsic layers are poor and the conversion efficiency of the cell is reduced under the condition of high doping concentrations in the prior art.

The present invention provides the preparation method of the heterojunction solar cell, comprising:
providing a substrate;
respectively depositing intrinsic layers at two sides of the substrate;
respectively depositing n-type doped layers and p-type doped layers on the intrinsic layers at two sides of the substrate, wherein at least two n-type doped layers and/or p-type doped layers are provided, and the doping concentration of each layer of the n-type doped layers and/or the p-type doped layers is gradually increased in a longitudinal direction away from the substrate; and
respectively and sequentially forming transparent conductive oxide layers and electrode layers on the n-type doped layers and the p-type doped layers.

Preferably, the thickness of each layer of the n-type doped layers and/or the p-type doped layers is gradually reduced in a longitudinal direction away from the substrate. Preferably, depositing the n-type doped layers on the intrinsic layers of the substrate comprises:
depositing a first n-type doped layer on the intrinsic layers, wherein the deposition conditions are that: the flow/volume ratio range of gases, namely H₂/SiH₄/PH₃, is equal to 4-10/2/1-2; the gas pressure range is larger than or equal to 0.3 mbar and smaller than or equal to 2.0 mbar; the radio frequency power range is larger than or equal to 500 W and smaller than or equal to 2000 W; and the thickness range is larger than 5 nm and
smaller than or equal to 10 nm;
depositing a second n-type doped layer on the first n-type doped layer, wherein the deposition conditions are that: the flow/volume ratio range of gases, namely H₂/SiH₄/PH₃, is equal to 4-10/2/2-3; the gas pressure range is larger than or equal to 0.3 mbar and smaller than or equal to 2.0 mbar; the radio frequency power range is larger than or equal to 500 W and smaller than or equal to 2000 W; and the thickness range is larger than 3 nm and smaller than or equal to 5 nm;
depositing a third n-type doped layer on the second n-type doped layer, wherein the deposition conditions are that: the flow/volume ratio range of gases, namely H₂/SiH₄/PH₃, is equal to 4-10/2/3-4; the gas pressure range is larger than or equal to 0.3 mbar and smaller than or equal to 2.0 mbar; the radio frequency power range is larger than or equal to 500 W and smaller than or equal to 2000 W; and the thickness range is larger than or equal to 1 nm and smaller than or equal to 3 nm;

Preferably, depositing each of the n-type doped layers is carried out after vacuumizing. Preferably, the conditions for depositing the p-type doped layers on the intrinsic layers of the substrate are that:
the flow/volume ratio range of gases, namely H₂/SiH₄/B₂H₆ is equal to 4-10/2/1-4; the gas pressure range is larger than or equal to 0.3 mbar and smaller than or equal to 2.0 mbar; the radio frequency power range is larger than or equal to 500 W and smaller than or equal to 2000 W; and the deposition thickness range is larger than or equal to 4nm and smaller than or equal to 10 nm.

Preferably, very high frequency-plasma enhanced chemical vapor deposition is adopted as a deposition way for the intrinsic layers.

Preferably, the deposition conditions of the intrinsic layers are that:
the flow/volume ratio range of gases, namely H₂/SiH₄ is equal to 0-10/1; the gas pressure range is larger than or equal to 0.3 mbar and smaller than or equal to 2.0 mbar; the radio frequency power range is larger than or equal to 200 W and smaller than or equal to 2000 W; and the deposition thickness range is larger than or equal to 5 nm and smaller than or equal to 15 nm.

Preferably, providing a substrate comprises:
carrying out texturing and/or cleaning pretreatment on the surface of the substrate. The present invention further provides a heterojunction solar cell comprising a substrate, intrinsic layers, n-type doped layers, p-type doped layers and electrode layers, wherein the intrinsic layers are arranged at two sides of the substrate, the n-type doped layers and the p-type doped layers are respectively arranged on the intrinsic layers at two sides of the substrate, and the electrode layers are respectively arranged on the n-type doped layers and the p-type doped layers at two sides of the substrate; and
at least two n-type doped layers and/or p-type doped layers are provided, and the doping concentration of each layer of the n-type doped layers and/or the p-type doped layers is gradually increased in a longitudinal direction away from the substrate.

Preferably, the thickness of each layer of the n-type doped layers and/or the p-type doped layers is gradually reduced in a longitudinal direction away from the substrate. Preferably, arranging the n-type doped layers on the intrinsic layers of the substrate comprises:
arranging a first n-type doped layer at the side close to the intrinsic layers;
arranging a second n-type doped layer on the first n-type doped layer; and
arranging a third n-type doped layer on the second n-type doped layer.

Preferably, the thickness range of the first n-type doped layer is larger than 5 nm and smaller than or equal to 10 nm; and the thickness range of the second n-type doped layer is larger than 3 nm and smaller than or equal to 5 nm, and the thickness range of the third n-type doped layer is larger than or equal to 1 nm and smaller than or equal to 3 nm.

Preferably, arranging the p-type doped layers on the intrinsic layers of the substrate comprises:
the thickness range of the p-type doped layers is larger than or equal to 4 nm and
smaller than or equal to 10 nm.

Preferably, the thickness range of the intrinsic layer is larger than or equal to 5 nm and smaller than or equal to 15 nm.

Compared with the prior art, the preparation method of the heterojunction solar cell and the heterojunction solar cell have the following advantages that:
according to the preparation method of the heterojunction solar cell, the n-type doped layers and the p-type doped layers are respectively deposited on the intrinsic layers at two sides of the substrate, at least two n-type doped layers and/or p-type doped layers are provided, and the doping concentration of each layer of the n-type doped layers and/or the p-type doped layers is gradually increased in a longitudinal direction away from the substrate, therefore, on one hand, the high-concentration doping of heterojunction solar energy may be realized, it may be ensured that the first intrinsic layer is prevented from being affected by impurity infiltration, a n/n+/n++ electric field of which the electric field direction is consistent with that of the pn junction is formed to increase the built-in electric field of the pn junction, so that the aim of increasing the conversion efficiency of the cell is achieved; on the other hand, in order to avoid low cell efficiency caused by overhigh interface state density, the p-type doped layers and the n-type doped layers cannot contact with each other, and depositing and doping are carried out in the longitudinal direction of the substrate without an additional masking process or a process of additionally removing a part of doped layers after doping, namely, when one side of the substrate is deposited and doped, it is unnecessary to mask or shield the other side of the substrate and carry out a doping removing process and other processes after doping is finished, and it is only needed that the other side should be deposited after the deposition of one side is finished, so that the production efficiency is increased.

### Brief Description of the Drawings

Fig.1 is a flow diagram of an embodiment of a preparation method of a heterojunction solar cell provided by the present invention; and
Fig.2 is a structural schematic diagram of an embodiment of a heterojunction solar cell provided by the present invention; and
Fig.3 is another structural schematic diagram of an embodiment of a heterojunction solar cell provided by the present invention; and
Fig.4 is another structural schematic diagram of an embodiment of a heterojunction solar cell provided by the present invention.

### Detailed Description of the Invention

Many specific details are set forth in the following description so as to facilitate sufficiently understanding the present invention. However, the present invention may be implemented in many other ways different from the way described herein, and similar popularization may be made by those skilled in the art without departing from the content of the present invention, so that the present invention is not limited by the disclosed specific embodiments below.

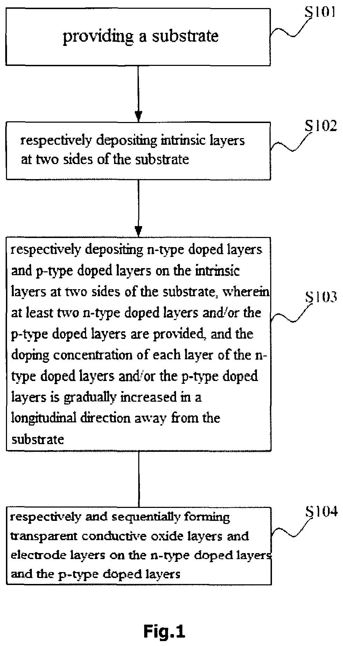

See Fig.1, it is a flow diagram of an embodiment of a preparation method of a heterojunction solar cell provided by the present invention.

The preparation method of the heterojunction solar cell provided by the present invention comprises:
step S101: providing a substrate;
the substrate in the step S101 may be a n-type monocrystalline silicon wafer, metal impurities and/or oil stains may exist on the substrate to affect performances of the cell, and therefore, the surface of the substrate may be subjected to texturing and/or cleaning pretreatment in order to improve the performances of the heterojunction solar cell.

In the embodiment, the next step is carried out after the surface of the substrate is respectively subjected to cleaning and texturing treatments. The oil stains, the metal impurities and the like on the surface of the substrate may be removed in the cleaning process, and normally, the impurities which may exist on the surface of the silicon wafer include organic matters such as grease, rosin, epoxy resin and polyethylene glycol; or metals, metal ions and some inorganic compounds; or dust or other particles (silicon and silicon carbide) and the like.

The cleaning ways may include physical cleaning and chemical cleaning. The physical cleaning comprises:
1. brushing or scrubbing: particle pollution and most of films stuck to the silicon wafer may be removed.
2. High-pressure cleaning: the surface of the silicon wafer is sprayed by using a liquid, and the pressure of a nozzle reaches up to several hundreds of atmospheric pressures. The high-pressure cleaning depends on a spray effect, so that the silicon wafer is not easily scratched and damaged. However, high-pressure spray may generate a static effect which is avoided by regulating the distance and angle between the nozzle and the silicon wafer or adding an antistatic agent.
3. Ultrasonic cleaning: ultrasonic waves may be transmitted into a solution to clean the pollution on the silicon wafer by virtue of a cavitation effect. However, it is relatively difficult to remove particles smaller than 1 µm from the graphic silicon wafer, and the cleaning effect is better if the frequency is increased to an ultrahigh frequency band.

The aim of the chemical cleaning is to remove atom and ion invisible pollution, and there are many methods such as a solvent extraction method, an acid pickling (sulfur acid, nitric acid, nitromuriatic acid, various mixed acids and the like) method and a plasma method.

Conventional chemical cleaning agents include high-purity water, an organic solvent, hydrogen peroxide, concentrated acid, strong alkaline, high-purity neutral cleaning agent and the like, wherein the hydrogen peroxide cleaning method is better in effect and little in environment pollution. In a general method, the silicon wafer is firstly cleaned by using an acidic solution in which the components H₂SO₄ and H₂O₂ are in the ratio of 5:1 or 4:1. The organic matters may be decomposed by virtue of the strong oxidation property of a cleaning solution so as to be removed; After being flushed by using ultrapure water, the silicon wafer is cleaned by using an alkaline cleaning solution in which the components H₂O, H₂O₂ and NH₄OH are in the ratio of 5:2:1 or 5:1:1 or 7:2:1, and many metal ions form a stable soluble complex under the oxidation effect of H₂O₂ and the complexing effect of NH₄OH so as to be dissolved into water; and then, the silicon wafer is cleaned by using an acidic cleaning solution in which the components H₂O, H₂O₂ and HCl are in the ratio of 7:2:1 or 5:2:1, and many metals generate complex ions dissolved into water due to the oxidation effect of H₂O₂, the dissolution of hydrochloric acid and the complexation of chlorine ions, so that a cleaning aim is achieved.

It should be understood that the specific implementation process of the cleaning treatment may be determined according to the condition of the surface of the substrate, for example, the adopted cleaning way, the use type of the cleaning agent, the cleaning time, a mixed solution used for texturing, the texturing time and the like may be determined according to the self-condition of the actual substrate.

The cleaned silicon wafer is required to be dried, so that the silicon wafer is prevented from being pollution again, and marks left by cleaning are prevented from being generated on the surface of the silicon wafer. Generally, the silicon wafer is dried in a spin drying way or by virtue of hot air or hot nitrogen, or a volatile liquid such as isopropanol is smeared on the surface of the silicon wafer, and the surface of the silicon wafer is dried by virtue of the rapid volatilization of the liquid; or the surface of the silicon wafer is directly air-dried.

Due to the adoption of texturing, the surface of the substrate may be rough to form a pyramidal texture surface, so that the absorption of the substrate to sunlight is increased. The texturing treatment may be carried out by virtue of anisotropic etching of silicon in a low-concentration alkaline solution, and furthermore, a pyramidal structure is formed on the surface of the silicon wafer. Generally, a mixed solution of NaOH, Na₂SiO₃ and the like is often adopted to react at 75-90 °C for 25-35 min during a texturing process.

It should be understood that the specific implementation process of the texturing treatment may be determined according to the condition of the surface of the substrate, such as the mixed solution used for texturing and the texturing time.

Step S102: respectively depositing intrinsic layers at two sides of the substrate;
the specific implementation process of the step S102 may be that the intrinsic layers are deposited on the substrate by using a very high frequency-plasma enhanced chemical vapor deposition (VHF-PECVD) method which may adopt 40 MHz high frequency-plasma enhanced chemical vapor deposition.

The specific deposition conditions may be that:
the flow/volume ratio range of the adopted gases, namely H₂/SiH₄ is equal to 0-10/1, and in the embodiment, the preferred flow/volume ratio, namely H₂/SiH₄ is equal to 4/1; the gas pressure range is larger than or equal to 0.3 mbar and smaller than or equal to 2.0 mbar, and in the embodiment, the preferred gas pressure value is 0.5 mbar; the radio frequency power range is larger than or equal to 200 W and smaller than or equal to 2000 W, and in the embodiment, the preferred radio frequency power value is 400 W, the deposition thickness range is larger than or equal to 5 nm, and the preferred thickness value is 10 nm.

It should be explained that the flow/volume ratio range of gases, namely H₂/SiH₄ is equal to 0-10/1 and refers to the flow/volume ratio range of hydrogen and silane introduced to a reaction chamber, the flow/volume ratio range of hydrogen (H₂) is larger than or equal to 0 and smaller than or equal to 10, and the flow/volume ratio range of silane (SiH₄) is equal to 1.

In order to better describe the deposition of the intrinsic layers, in the embodiment, a first intrinsic layer and a second intrinsic layer are respectively deposited at two sides of the substrate, namely the first intrinsic layer and the second intrinsic layer are located at two sides of the substrate in a longitudinal direction.

Step S103: respectively depositing n-doped layers and p-doped layers on the intrinsic layers at two sides of the substrate, wherein at least two n-type doped layers and/or p-type doped layers are provided, and the doping concentration of each layer of the n-doped layers and/or the p-doped layers is gradually increased in a longitudinal direction away from the substrate.

In this embodiment, both sides of the substrate are defined as a first side and a second side, a first intrinsic layer is deposited at the first side of the substrate, and a second intrinsic layer is deposited at the second side of the substrate. An n-type doped layer and a p-type doped layer are respectively deposited on the intrinsic layers at both sides of the substrate, namely the n-type doped layers are deposited on the first intrinsic layer and the p-type doped layers are deposited on the second intrinsic layer in the longitudinal direction.

The specific implementation process of the step S103 is that at least two n-type doped layers and/or at least two p-type doped layers are respectively deposited on the intrinsic layers at two sides of the substrate, namely the n-type doped layers are deposited on the first intrinsic layer and the p-type doped layers are deposited on the second intrinsic layer in the longitudinal direction, moreover, at least two n-type doped layers are provided, and/or at least two p-type doped layers are provided.

In the embodiment, three of the n-type doped layers are deposited on the first intrinsic layer, one of the p-type doped layers is deposited on the second intrinsic layer, and the specific deposition way is as follows:
the first n-type doped layer is deposited on the first intrinsic layer, and the specific deposition way is as follows:
the flow/volume ratio range of the adopted gases, namely H₂/SiH₄/PH₃, is equal to 4-10/2/1-2, and in the embodiment, the preferred flow/volume ratio of gases, namely H₂/SiH₄/PH₃, is equal to 6/2/1; the gas pressure range is larger than or equal to 0.3 mbar and smaller than or equal to 2.0 mbar, and in the embodiment, the preferred gas pressure value is 0.8 mbar; the radio frequency power range is larger than or equal to 500 W and smaller than or equal to 2000 W, and in the embodiment, the preferred radio frequency power value is 1000 W; and the deposition thickness range is larger than 5 nm and smaller than or equal to 10 nm, and in the embodiment, the preferred deposition thickness value is 6 nm.

It should be explained that the flow/volume ratio range of gases, namely H₂/SiH₄/PH₃, is equal to 4-10/2/1-2 and means that the flow/volume ratio range of hydrogen (H₂) is larger than or equal to 4 and smaller than or equal to 10; the flow/volume ratio range of silane (SiH₄) is equal to 2; and the flow/volume ratio range of phosphine (PH₃) is larger than or equal to 1 and smaller than or equal to 2;
the second n-type doped layer is deposited on the first n-type doped layer, and the specific deposition way is as follows:
the flow/volume ratio range of the adopted gases, namely H₂/SiH₄/PH₃, is equal to 4-10/2/2-3, and in the embodiment, the preferred flow/volume ratio of gases, namely H₂/SiH₄/PH₃, is equal to 5/2/2; the gas pressure range is larger than or equal to 0.3 mbar and smaller than or equal to 2.0 mbar, and in the embodiment, the preferred gas pressure value is 0.8 mbar; the radio frequency power range is larger than or equal to 800 W and smaller than or equal to 1200 W, and in the embodiment, the preferred radio frequency power value is 1000 W; and the deposition thickness range is larger than 3 nm and smaller than or equal to 5 nm, and in the embodiment, the preferred deposition thickness value is 4 nm.

It should be explained that the flow/volume ratio range of gases, namely H₂/SiH₄/PH₃, is equal to 4-10/2/2-3 and means that the flow/volume ratio range of hydrogen (H₂) is larger than or equal to 4 and smaller than or equal to 10; the flow/volume ratio range of silane (SiH₄) is equal to 2; and the flow/volume ratio range of phosphine (PH₃) is larger than or equal to 2 and smaller than or equal to 3;
the third n-type doped layer is deposited on the second n-type doped layer, and the specific deposition way is as follows:
the flow/volume ratio range of the adopted gases, namely H₂/SiH₄/PH₃, is equal to 4-10/2/3-4, and in the embodiment, the preferred flow/volume ratio of gases, namely H₂/SiH₄/PH₃, is equal to 4/2/3; the gas pressure range is larger than or equal to 0.6 mbar and smaller than or equal to 1.0 mbar, and in the embodiment, the preferred gas pressure value is 0.8 mbar; the radio frequency power range is larger than or equal to 800 W and smaller than or equal to 1200 W, and in the embodiment, the preferred radio frequency power value is 1000 W; and the deposition thickness range is larger than 1 nm and smaller than or equal to 3 nm, and in the embodiment, the preferred deposition thickness value is 2 nm.

It should be explained that the flow/volume ratio range of gases, namely H₂/SiH₄/PH₃, is equal to 4-10/2/3-4 and means that the flow/volume ratio range of hydrogen (H₂) is larger than or equal to 4 and smaller than or equal to 10; the flow/volume ratio range of silane (SiH₄) is equal to 2; and the flow/volume ratio range of phosphine (PH₃) is larger than or equal to 3 and smaller than or equal to 4;
it should be understood that each n-type doped layer may have different concentrations by controlling the flow/volume of the gases introduced to the reaction chamber when the first n-type doped layer, the second n-type doped layer and the third n-type doped layer are deposited, for example, the flow/volume ratio of the gases, namely H₂/SiH₄/PH₃ introduced to the reaction chamber when the first n-type doped layer is deposited is equal to 6/2/1; the flow/volume ratio of the gases, namely H₂/SiH₄/PH₃ introduced to the reaction chamber when the second n-type doped layer is deposited is equal to 5/2/2; the flow/volume ratio of the gases, namely H₂/SiH₄/PH₃ introduced to the reaction chamber when the third n-type doped layer is deposited is equal to 4/2/3; and namely the doping concentrations of the n-type doped layers are controlled by regulating the flows/volumes of hydrogen (H₂) and phosphine (PH₃) introduced to the reaction chamber under the condition that the introduction amount of silane is constant. In the embodiment, the flow/volume ratio of the gases introduced in the process that the first n-type doped layer, the second n-type doped layer and the third n-type doped layer are deposited is gradually increased, namely the doping concentration of the first n-type doped layer is smaller than that of the second n-type doped layer, and the doping concentration of the second n-type doped layer is smaller than that of the third n-type doped layer, i.e. graded doping.

In the embodiment, the doping concentration of each n-type doped layer is controlled by regulating the flow/volume ratio of the introduced gases, and it should be understood that the doping concentration of each n-type doped layer may also be controlled by regulating the mass percentage concentration of the gases introduced to the reaction chamber, namely the mass percentage concentration of the gases is gradually increased when each n-type doped layer is deposited in the longitudinal direction.

In the embodiment, in order to reduce the occupied space of the heterojunction solar cell after the doped layers are additionally arranged on the integral structure of the heterojunction solar cell, the deposition thickness of each n-type doped layer is gradually reduced in a longitudinal direction away from the substrate, namely the thickness of the first n-type doped layer is larger than that of the second n-type doped layer, and the thickness of the second n-type doped layer is larger than that of the third n-type doped layer; for example, in the embodiment, the deposition thickness of the first n-type doped layer is 6 nm, the deposition thickness of the second n-type doped layer is 4 nm, and the deposition thickness of the third n-type doped layer is 2 nm.

It should be explained that the reaction chamber is vacuumized before reaction gases are introduced to the reaction chamber in a process that the first n-type doped layer, the second n-type doped layer and the third n-type doped layer are deposited in the embodiment, so that it is ensured that no residual gases are left in the reaction chamber, without affecting the subsequent deposition reaction process.

In the embodiment, after the deposition of the first n-type doped layer, the second n-type doped layer and the third n-type doped layer on the first intrinsic layer is finished, the substrate is overturned, and the p-type doped layers are deposited on the second intrinsic layer.

The conditions for depositing the p-type doped layers on the second intrinsic layer are that:
the flow/volume ratio of the adopted gases, namely H₂/SiH₄/B₂H₆ is equal to 6/2/1; the gas pressure range is larger than or equal to 0.6 mbar and smaller than or equal to 1.0 mbar, and in the embodiment, the preferred gas pressure value is 0.8 mbar; the radio frequency power range is larger than or equal to 800 W and smaller than or equal to 1200 W, and in the embodiment, the preferred radio frequency power value is 1000 W; and the deposition thickness range is larger than 4 nm and smaller than or equal to 10 nm, and in the embodiment, the preferred deposition thickness value is 8 nm.

In the embodiment, the plurality of n-type doped layers are formed at a single side, which has the advantages that:
1. the plurality of n-type doped layers are sequentially and longitudinally deposited on the first intrinsic layer, and the doping concentrations are gradually increased, so that the heterojunction solar energy may have high-concentration doping to ensure that the first intrinsic layer is prevented from being affected by impurity infiltration, and a n/n+/n++ electric field of which the electric field direction is consistent with that of the pn junction is formed to increase the built-in electric field of the pn junction, for achieving the aim of increasing the conversion efficiency of the cell;
2. in order to avoid low cell efficiency caused by overhigh interface state density, the p-type doped layers and the n-type doped layers cannot contact with each other, and depositing and doping are carried out in the longitudinal direction of the substrate without an additional masking process or a process of additionally removing a part of doped layers after doping, namely, when one side of the substrate is deposited and doped, it is unnecessary to mask or shield the other side of the substrate and carry out a doping removing process and other processes after doping is finished, and it is only needed that the other side should be deposited after the deposition of one side is finished, so that the production efficiency is increased.

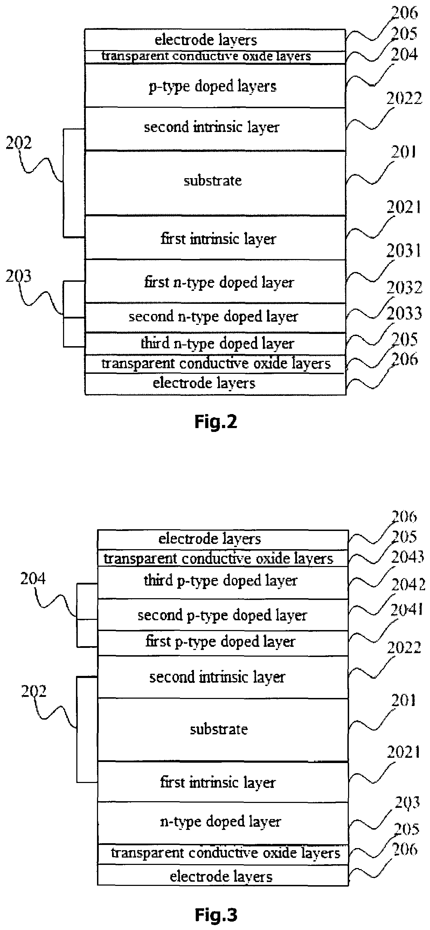

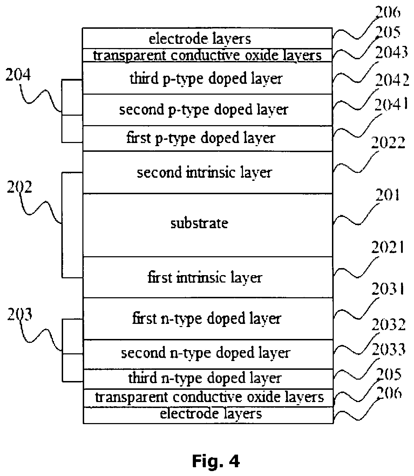

It should be explained that according to the preparation method of the heterojunction solar cell provided by the present invention, the plurality of n-type doped layers may be respectively and sequentially deposited on the first intrinsic layer according to different demands, and one of the p-type doped layers is deposited on the second intrinsic layer, as seen in Fig.2; or the plurality of p-type doped layers are respectively and sequentially deposited on the second intrinsic layer, and one of the n-type doped layers is deposited on the first intrinsic layer, as seen in Fig.3; or the plurality of n-type doped layers are sequentially deposited on the first intrinsic layer, and the plurality of p-type doped layers are sequentially deposited on the second intrinsic layer, as seen in Fig.4.

The first intrinsic layer and the second intrinsic layer are same in deposition conditions and structures and are distinguished by first and second to be only intended to provide convenience for description, but not limit the deposition sequences of both.

The deposition conditions may be set to deposit the other side after depositing one side, the specific deposition layer number is determined according to an actual demand, and the deposition ways of the plurality of doped layers (the plurality of n-type doped layers and/or the plurality of p-type doped layers) may also be set according to a specific demand.

The examples in the embodiment merely aims at describing the preparation process of the heterojunction solar cell provided by the present invention, rather than limiting each parameter, way and the like in the specific deposition process.

Step S104: respectively and sequentially forming transparent conductive oxide layers and electrode layers on the n-type doped layers and the p-type doped layers.

That is, the transparent conductive oxide layers and the electrode layers are sequentially formed on the n-type doped layers, and the transparent conductive oxide layers and the electrode layers are sequentially formed on the p-type doped layers.

The specific implementation process of the step S104 may be that the transparent conductive oxide layers are respectively and sequentially formed on the n-type doped layers and the p-type doped layers by using a physical vapor deposition (PVD) method. The PVD method comprises vacuum evaporation coating, sputtering coating and ion coating; the vacuum evaporation coating is to heat a source material to be evaporated; the sputtering coating is to bombard a source material target by using particles with a certain energy to sputter source material atoms from the target; and the ion coating is to irradiate the target by using laser and evaporate a target material and form a plasma by utilizing a thermal effect.

In the embodiment, the transparent conductive oxide (TCO) layers are sputtered by sputtering coating, and the sputtering coating deposition method has the advantages that the sputtering coating is not limited by the target and is high in purity as well as good in compactness and bonding property.

In the embodiment, the TCO layers are deposited on the third n-type doped layer and the p-type doped layers.

The electrode layers are formed on the TCO layers after the TCO layers are deposited, and the electrode layers may be achieved by using a screen printing process.

Reducing interface recombination of the heterojunction cell is beneficial to the collection and transportation of photocarriers and the increment of conversion efficiency of the cells. For high-concentration n-type doping, although the built-in electric field of the pn junction may be increased, more impurities may be introduced into the intrinsic layers to reduce the passivation effects of the intrinsic layers, and in the embodiment, low-concentration doping is adopted on the surface in contact with the intrinsic layers (or the side close to the intrinsic layers), so that the impurities on the n-type doped layers are prevented from being infiltrated into the intrinsic layers, the passivation effects of the intrinsic layers are guaranteed, and the surface recombination of the cell is reduced; meanwhile, gradient heavy doping is carried out on a low-concentration doped layer, namely the doping concentrations are gradually increased from the longitudinal direction close to the intrinsic layers to the longitudinal direction away from the intrinsic layers, so that the built-in electric field in the pn junction is effectively increased; and on the other hand, the n-type doped layers in contact with the TCO layers are heavily doped, which is beneficial to the reduction of contact resistance of the n-type doped layers and the TCO layers and the improvement of the transportation capacity of carriers, and furthermore, the conversion efficiency of the cell is increased. The embodiment of the preparation method of the heterojunction solar cell provided by the present invention, is described above in detail, a specific structure of the heterojunction solar cell provided by the present invention is introduced below in conjunction with the above description of the method, and the specific introduction is as follows:
See Fig.2, it is a structural schematic diagram of an embodiment of a heterojunction solar cell provided by the present invention, and the heterojunction solar cell provided by the present invention comprises:
a substrate 201, intrinsic layers 202, n-type doped layers 203, p-type doped layers 204, transparent conductive oxide layers 205 and electrode layers 206.

The intrinsic layers 202 are arranged at two sides of the substrate 201, the n-type doped layers 203 and the p-type doped layers 204 are respectively arranged on the intrinsic layers 202 at two sides of the substrate 201, and the electrode layers 206 are respectively arranged on the n-type doped layers 203 and the p-type doped layers 204 at two sides of the substrate 201; and
at least two n-type doped layers 203 and/or p-type doped layers 204 are provided, and the doping concentration of each layer of the n-type doped layers 203 and/or the p-type doped layers 204 is gradually increased in a longitudinal direction away from the substrate 201.

In the embodiment, it is described that the plurality of n-type doped layers 203 are arranged on the intrinsic layers 202, namely:
a first n-type doped layer 2031 is arranged at the side close to one of the intrinsic layers 202;
a second n-type doped layer 2032 is arranged on the first n-type doped layer 2031; and a third n-type doped layer 2033 is arranged on the second n-type doped layer 2032.

In order to more clearly know about the structure of the cell in the embodiment, the names of the intrinsic layers 202 are limited, namely two sides in the longitudinal direction of the substrate 201 are respectively a first intrinsic layer 2021 and a second intrinsic layer 2022.

The first n-type doped layer 2031 is arranged on the first intrinsic layer 2021, the second n-type doped layer 2032 is arranged on the first n-type doped layer 2031, and the third n-type doped layer 2033 is arranged on the second n-type doped layer 2032. The thickness range of the first n-type doped layer 2031 is larger than 5 nm and smaller than or equal to 10 nm, and in the embodiment, the preferred deposition thickness value is 6 nm.

The thickness range of the second n-type doped layer 2032 is larger than 3 nm and smaller than or equal to 5 nm, and in the embodiment, the preferred deposition thickness value is 4 nm.

The thickness range of the third n-type doped layer 2033 is larger than or equal to 1 nm and smaller than or equal to 3 nm, and in the embodiment, the preferred deposition thickness value is 2 nm.

The p-type doped layers 204 are arranged on the second intrinsic layer 2022, the thickness range of the p-type doped layers 204 is larger than or equal to 10 nm and smaller than or equal to 6 nm, and in the embodiment, the preferred deposition thickness value is 8 nm.

The thickness ranges of each of the first intrinsic layer 2021 and the second intrinsic layer 2022 is larger than or equal to 5 nm and smaller than or equal to 15 nm, and in the embodiment, the preferred deposition thickness value is 10 nm.

The preferred embodiments are disclosed as above, but are not intended to limit the present invention, any possible variations and modifications may be made by those skilled in the art without departing from the spirit and scope of the present invention, and therefore, the scope of the present invention should be subject to the scope defined in the claims of the present invention.

## Claims

1. A preparation method of a heterojunction solar cell, comprising:
providing a substrate;
respectively depositing intrinsic layers at two sides of the substrate;
respectively depositing n-type doped layers and p-type doped layers on the intrinsic layers at two sides of the substrate, wherein at least two n-type doped layers and/or p-type doped layers are provided, and the doping concentration of each layer of the n-type doped layers and/or the p-type doped layers is gradually increased in a longitudinal direction away from the substrate; and
respectively and sequentially forming transparent conductive oxide layers and electrode layers on the n-type doped layers and the p-type doped layers.

2. The preparation method of the heterojunction solar cell of claim 1, wherein the thickness of each layer of the n-type doped layers and/or the p-type doped layers is gradually reduced in a longitudinal direction away from the substrate.

3. The preparation method of the heterojunction solar cell of claim 1 or claim 2, wherein depositing the n-type doped layers on the intrinsic layers of the substrate comprises:
depositing a first n-type doped layer on the intrinsic layers, wherein the deposition conditions are that: the flow/volume ratio range of gases, namely H₂/SiH₄/PH₃, is equal to 4-10/2/1-2; the gas pressure range is larger than or equal to 0.3 mbar and smaller than or equal to 2.0 mbar; the radio frequency power range is larger than or equal to 500 W and smaller than or equal to 2000 W; and the thickness range is larger than 5 nm and
smaller than or equal to 10 nm;
depositing a second n-type doped layer on the first n-type doped layer, wherein the deposition conditions are that: the flow/volume ratio range of gases, namely H₂/SiH₄/PH₃, is equal to 4-10/2/2-3; the gas pressure range is larger than or equal to 0.3 mbar and smaller than or equal to 2.0 mbar; the radio frequency power range is larger than or equal to 500 W and smaller than or equal to 2000 W; and the thickness range is larger than 3 nm and smaller than or equal to 5 nm;
depositing a third n-type doped layer on the second n-type doped layer, wherein the deposition conditions are that: the flow/volume ratio range of gases, namely H₂/SiH₄/PH₃, is equal to 4-10/2/3-4; the gas pressure range is larger than or equal to 0.3 mbar and smaller than or equal to 2.0 mbar; the radio frequency power range is larger than or equal to 500 W and smaller than or equal to 2000 W; and the thickness range is larger than or equal to 1 nm and smaller than or equal to 3 nm.

4. The preparation method of the heterojunction solar cell of claim 3, wherein depositing each of the n-type doped layers is carried out after vacuumizing.

5. The preparation method of the heterojunction solar cell of any of claims 1 to 4, wherein the conditions for depositing the p-type doped layers on the intrinsic layers of the substrate are that:
the flow/volume ratio range of gases, namely H₂/SiH₄/B₂H₆ is equal to 4-10/2/1-4; the gas pressure range is larger than or equal to 0.3 mbar and smaller than or equal to 2.0 mbar; the radio frequency power range is larger than or equal to 500 W and smaller than or equal to 2000 W; and the deposition thickness range is larger than or equal to 4 nm and smaller than or equal to 10 nm.

6. The preparation method of the heterojunction solar cell of any of claims 1 to 5, wherein very high frequency-plasma enhanced chemical vapor deposition is adopted as a deposition way for the intrinsic layers.

7. The preparation method of the heterojunction solar cell of claim 6, wherein the deposition conditions of the intrinsic layers are that:
the flow/volume ratio range of gases, namely H₂/SiH₄ is equal to 0-10/1; the gas pressure range is larger than or equal to 0.3 mbar and smaller than or equal to 2.0 mbar; the radio frequency power range is larger than or equal to 200 W and smaller than or equal to 2000 W; and the deposition thickness range is larger than or equal to 5 nm and smaller than or equal to 15 nm.

8. The preparation method of the heterojunction solar cell of any of claims 1 to 7, wherein providing a substrate comprises:
carrying out texturing and/or cleaning pretreatment on the surface of the substrate.

9. A heterojunction solar cell comprising a substrate, intrinsic layers, n-type doped layers, p-type doped layers and electrode layers, wherein the intrinsic layers are arranged at two sides of the substrate, the n-type doped layers and the p-type doped layers are respectively arranged on the intrinsic layers at two sides of the substrate, and the electrode layers are respectively arranged on the n-type doped layers and the p-type doped layers at two sides of the substrate; and
at least two n-type doped layers and/or p-type doped layers are provided, and the doping concentration of each layer of the n-type doped layers and/or the p-type doped layers is gradually increased in a longitudinal direction away from the substrate.

10. The heterojunction solar cell of claim 9, wherein the thickness of each layer of the n-type doped layers and/or the p-type doped layers is gradually reduced in a longitudinal direction away from the substrate.

11. The heterojunction solar cell of claim 9 or claim 10, wherein the n-type doped layers are arranged on the intrinsic layers such that:
a first n-type doped layer is arranged at the side close to the intrinsic layers;
a second n-type doped layer is arranged on the first n-type doped layer; and
a third n-type doped layer is arranged on the second n-type doped layer.

12. The heterojunction solar cell of claim 11, wherein the thickness range of the first n-type doped layer is larger than 5 nm and smaller than or equal to 10 nm; the thickness range of the second n-type doped layer is larger than 3 nm and smaller than or equal to 5 nm; and the thickness range of the third n-type doped layer is larger than or equal to 1 nm and smaller than or equal to 3 nm.

13. The heterojunction solar cell of claim 11 or claim 12, wherein the thickness range of the p-type doped layers arranged on the intrinsic layers of the substrate is larger than or equal to 4 nm and smaller than or equal to 10 nm.

14. The heterojunction solar cell of any of claims 9 to 13, wherein the thickness range of the intrinsic layer is larger than or equal to 5 nm and smaller than or equal to 15 nm.
